(19) **Europäisches Patentamt / European Patent Office / Office européen des brevets**

(11) **EP 1 835 487 B1**

(12) **EUROPEAN PATENT SPECIFICATION**

(45) Date of publication and mention
of the grant of the patent:
**10.07.2013 Bulletin 2013/28**

(51) Int Cl.:
*H03G 9/00* (2006.01)  *H03G 9/02* (2006.01)

(21) Application number: **07013246.9**

(22) Date of filing: **27.05.2004**

(54) **Method, apparatus and computer program for calculating and adjusting the perceived loudness of an audio signal**

Verfahren, Vorrichtung und Computerprogramm zur Berechnung und Anpassung der wahrgenommenen Lautstärke eines Audiosignals

Procédé, appareil et programme informatique pour calculer et régler le volume perçu d'un signal audio

(84) Designated Contracting States:
**AT BE BG CH CY CZ DE DK EE ES FI FR GB GR HU IE IT LI LU MC NL PL PT RO SE SI SK TR**

(30) Priority: **28.05.2003 US 474077 P**

(43) Date of publication of application:
**19.09.2007 Bulletin 2007/38**

(62) Document number(s) of the earlier application(s) in accordance with Art. 76 EPC:
**04776174.7 / 1 629 463**

(73) Proprietor: **DOLBY LABORATORIES LICENSING CORPORATION**
**San Francisco**
**California 94103 (US)**

(72) Inventors:
• **Seefeldt, Alan Jeffrey**
**San Francisco**
**California 94103 (US)**
• **Smithers, Michael John**
**San Francisco**
**California 94103 (US)**
• **Crockett, Brett Graham**
**San Francisco**
**California 94103 (US)**

(74) Representative: **MERH-IP**
**Matias Erny Reichl Hoffmann**
**Paul-Heyse-Strasse 29**
**80336 München (DE)**

(56) References cited:
**US-A- 5 822 018**

• **GLASBERG B R ET AL: "A MODEL OF LOUDNESS APPLICABLE TO TIME-VARYING SOUNDS" JOURNAL OF THE AUDIO ENGINEERING SOCIETY, AUDIO ENGINEERING SOCIETY. NEW YORK, US, vol. 50, no. 5, May 2002 (2002-05), pages 331-342, XP001130128 ISSN: 0004-7554**
• **VICKERS E: "Automatic Long-Term Loudness and Dynamics Matching" AUDIO ENGINEERING SOCIETY CONVENTION PAPER, NEW YORK, NY, US, 21 September 2001 (2001-09-21), pages 1-11, XP002317489**
• **MOORE B C J ET AL: "A MODEL FOR THE PREDICTION OF THRESHOLDS, LOUDNESS, AND PARTIAL LOUDNESS" JOURNAL OF THE AUDIO ENGINEERING SOCIETY, AUDIO ENGINEERING SOCIETY. NEW YORK, US, vol. 45, no. 4, 1 April 1997 (1997-04-01), pages 224-240, XP000700661 ISSN: 0004-7554**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### *Technical Field*

The present invention is related to loudness measurements of audio signals and to apparatuses, methods, and computer programs for controlling the loudness of audio signals in response to such measurements.

### *Background*

Loudness is a subjectively perceived attribute of auditory sensation by which sound can be ordered on a scale extending from quiet to loud. Because loudness is a sensation perceived by a listener, it is not suited to direct physical measurement, therefore making it difficult to quantify. In addition, due to the perceptual component of loudness, different listeners with "normal" hearing may have different perceptions of the same sound. The only way to reduce the variations introduced by individual perception and to arrive at a general measure of the loudness of audio material is to assemble a group of listeners and derive a loudness figure, or ranking, statistically. This is clearly an impractical approach for standard, day-to-day, loudness measurements.

There have been many attempts to develop a satisfactory objective method of measuring loudness. Fletcher and Munson determined in 1933 that human hearing is less sensitive at low and high frequencies than at middle (or voice) frequencies. They also found that the relative change in sensitivity decreased as the level of the sound increased. An early loudness meter consisted of a microphone, amplifier, meter and a combination of filters designed to roughly mimic the frequency response of hearing at low, medium and high sound levels.

Even though such devices provided a measurement of the loudness of a single, constant level, isolated tone, measurements of more complex sounds did not match the subjective impressions of loudness very well. Sound level meters of this type have been standardized but are only used for specific tasks, such as the monitoring and control of industrial noise.

In the early 1950s, Zwicker and Stevens, among others, extended the work of Fletcher and Munson in developing a more realistic model of the loudness perception process. Stevens published a method for the "Calculation of the Loudness of Complex Noise" in the Journal of the Acoustical Society of America in 1956, and Zwicker published his "Psychological and Methodical Basis of Loudness" article in Acoustica in 1958. In 1959 Zwicker published a graphical procedure for loudness calculation, as well as several similar articles shortly after. The Stevens and Zwicker methods were standardized as ISO 532, parts A and B (respectively). Both methods incorporate standard psychoacoustic phenomena such as critical banding, frequency masking and specific loudness. The methods are based on the division of complex sounds into components that fall into "critical bands" of frequencies, allowing the possibility of some signal components to mask others, and the addition of the specific loudness in each critical band to arrive at the total loudness of the sound.

Recent research, as evidenced by the Australian Broadcasting Authority's (ABA) "investigation into Loudness of Advertisements" (July 2002), has shown that many advertisements (and some programs) are perceived to be too loud in relation to the other programs, and therefore are very annoying to the listeners. The ABA's investigation is only the most recent attempt to address a problem that has existed for years across virtually all broadcast material and countries. These results show that audience annoyance due to inconsistent loudness across program material could be reduced, or eliminated, if reliable, consistent measurements of program loudness could be made and used to reduce the annoying loudness variations.

The document US 5,822,018 A addresses this problem and describes an apparatus and method to normalize the audio signal levels of the program and the advertisements so that the audio portion of the output signal being transmitted to listeners will have a relatively uniform loudness. In this prior art an audio signal is input to a level detector approximating a standard A-weighting curve by passing the audio signal in this order through a band-pass filter, a low-pass filter, a high-pass filter, a full-wave rectifier and a dB circuit for conversion of the processed signal to a logarithmic representation. The resulting signal is compared with an audio reference level and the difference is used to set the level of the audio signal to be controlled.

The Bark scale is a unit of measurement used in the concept of critical bands. The critical-band scale is based on the fact that human hearing analyses a broad spectrum into parts that correspond to smaller critical sub-bands. Adding one critical band to the next in such a way that the upper limit of the lower critical band is the lower limit of the next higher critical band, leads to the scale of critical-band rate. If the critical bands are added up this way, then a certain frequency corresponds to each crossing point. The first critical band spans the range from 0 to 100 Hz, the second from 100 Hz to 200 Hz, the third from 200 Hz to 300 Hz and so on up to 500 Hz where the frequency range of each critical band increases. The audible frequency range of 0 to 16 kHz can be subdivided into 24 abutting critical bands, which increase in bandwidth with increasing frequency. The critical bands are numbered from 0 to 24 and have the unit "Bark", defining the Bark scale. The relation between critical-band rate and frequency is important for understanding many characteristics of the human ear. See, for example, Psychoacoustics - Facts and Models by E. Zwicker and H. Fastl, Springer-Verlag, Berlin, 1990.

The Equivalent Rectangular Bandwidth (ERB) scale is a way of measuring frequency for human hearing that is similar to the Bark scale. Developed by Moore, Glasberg and Baer, it is a refinement of Zwicker's loudness work. See Moore, Glasberg and Baer (B. C. J. Moore, B. Glasberg, T. Baer, "A Model for the Prediction of Thresholds, Loudness, and Partial Loudness," Journal of the Audio Engineering Society, Vol. 45, No. 4, April 1997, pp. 224-240). The measurement of critical bands below 500 Hz is difficult because at such low frequencies, the efficiency and sensitivity of the human auditory system diminishes rapidly. Improved measurements of the auditory-filter bandwidth have lead to the ERB-rate scale. Such measurements used notched-noise maskers to measure the auditory filter bandwidth. In general, for the ERB scale the auditory-filter bandwidth (expressed in units of ERB) is smaller than on the Bark scale. The difference becomes larger for lower frequencies.

The frequency selectivity of the human hearing system can be approximated by subdividing the intensity of sound into parts that fall into critical bands. Such an approximation leads to the notion of critical band intensities. If instead of an infinitely steep slope of the hypothetical critical band filters, the actual slope produced in the human hearing system is considered, then such a procedure leads to an intermediate value of intensity called excitation. Mostly, such values are not used as linear values but as logarithmic values similar to sound pressure level. The critical-band and excitation levels are the corresponding values that play an important role in many models as intermediate values. (See *Psychoacoustics - Facts and Models, supra*). '

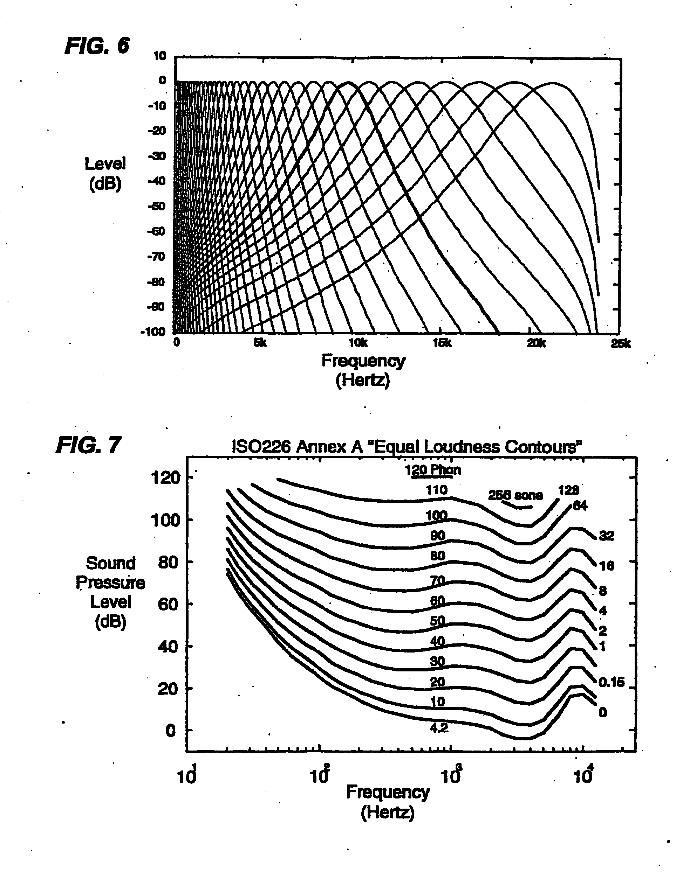

Loudness level may be measured in units of "phon". One phon is defined as the perceived loudness of a 1 kHz pure sine wave played at 1 dB sound pressure level (SPL), which corresponds to a root mean square pressure of $2 \times 10^{-5}$ Pascals. N Phon is the perceived loudness of a 1 kHz tone played at N dB SPL. Using this definition in comparing the loudness of tones at frequencies other than 1 kHz with a tone at 1 kHz, a contour of equal loudness can be determined for a given level of phon. FIG. 7 shows equal loudness level contours for frequencies between 20 Hz and 12.5 kHz, and for phon levels between 4.2 phon (considered to be the threshold of hearing) and 120 phon (ISO226: 1987 (E), "Acoustics - Normal Equal Loudness Level Contours").

Loudness level may also be measured in units of "sone". There is a one-to-one mapping between phon units and sone units, as indicated in FIG. 7. One sone is defined as the loudness of a 40 dB (SPL) 1 kHz pure sine wave and is equivalent to 40 phon. The units of sone are such that a twofold increase in sone corresponds to a doubling of perceived loudness. For example, 4 sone is perceived as twice as loud as 2 sone. Thus, expressing loudness levels in sone is more informative.

Because sone is a measure of loudness of an audio signal, specific loudness is simply loudness per unit frequency. Thus when using the bark frequency scale, specific loudness has units of sone per bark and likewise when using the ERB frequency scale, the units are sone per ERB.

Throughout the remainder of this document, terms such as "filter" or "filterbank" are used herein to include essentially any form of recursive and non-recursive filtering such as IIR filters or transforms, and "filtered" information is the result of applying such filters. Embodiments described below employ filterbanks implemented by IIR filters and by transforms.

### *Disclosure of the Invention*

The scope of the invention is defined in the appended claims.

The various aspects of the present invention and its preferred embodiments may be better understood by referring to the following disclosure and the accompanying drawings in which the like reference numerals refer to the like elements in the several figures. The drawings, which illustrate various devices or processes, show major elements that are helpful in understanding the present invention. For the sake of clarity, the drawings omit many other features that may be important in practical embodiments and are well known to those of ordinary skill in the art but are not important to understanding the concepts of the present invention. The signal processing for practicing the present invention may be accomplished in a wide variety of ways including programs executed by microprocessors, digital signal processors, logic arrays and other forms of computing circuitry.

### *Brief Description of the Drawings*

FIG. I is a schematic functional block diagram of an embodiment of an aspect of the present invention.
FIG. 2 is a schematic functional block diagram of an embodiment of a further aspect of the present invention.
FIG. 3 is a schematic functional block diagram of an embodiment of yet a further aspect of the present invention.
FIG. 4 is an idealized characteristic response of a linear filter P(z) suitable as a transmission filter in an embodiment of the present invention in which the vertical axis is attenuation in decibels (dB) and the horizontal axis is a logarithmic base 10 frequency in Hertz (Hz).

FIG. 5 shows the relationship between the ERB frequency scale (vertical axis) and frequency in Hertz (horizontal axis).

FIG. 6 shows a set idealized auditory filter characteristic responses that approximate critical banding on the ERB scale. The horizontal scale is frequency in Hertz and the vertical scale is level in decibels.

FIG. 7 shows the equal loudness contours of ISO266. The horizontal scale is frequency in Hertz (logarithmic base 10 scale) and the vertical scale is sound pressure level in decibels.

FIG. 8 shows the equal loudness contours of ISO266 normalized by the transmission filter $P(z)$. The horizontal scale is frequency in Hertz (logarithmic base 10 scale) and the vertical scale is sound pressure level in decibels.

FIG. 9 (solid lines) shows plots of loudness for both uniform-exciting noise and a 1 kHz tone in which solid lines are in accordance with an embodiment of the present invention in which parameters are chosen to match experimental data according to Zwicker (squares and circles). The vertical scale is loudness in sone (logarithmic base 10) and the horizontal scale is sound pressure level in decibels.

FIG. 10 is a schematic functional block diagram of an embodiment of a further aspect of the present invention.

FIG. 11 is a schematic functional block diagram of an embodiment of yet a further aspect of the present invention.

FIG. 12 is a schematic functional block diagram of an embodiment of another aspect of the present invention.

FIG. 13 is a schematic functional block diagram of an embodiment of another aspect of the present invention.

## Modes for Carrying Out the Invention

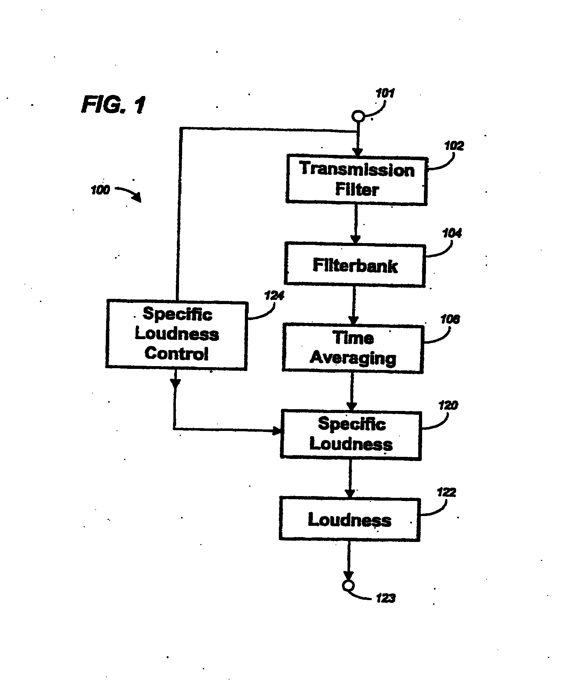

As described in greater detail below, an embodiment of a first aspect of the present invention, shown in FIG. 1, includes a specific loudness controller or controller function ("Specific Loudness Control") 124 that analyzes and derives characteristics of an input audio signal. The audio characteristics are used to control parameters in a specific loudness converter or converter function ("Specific Loudness") 120. By adjusting the specific loudness parameters using signal characteristics, the objective loudness measurement technique of the present invention may be matched more closely to subjective loudness results produced by statistically measuring loudness using multiple human listeners. The use of signal characteristics to control loudness parameters may also reduce the occurrence of incorrect measurements that result in signal loudness deemed annoying to listeners.

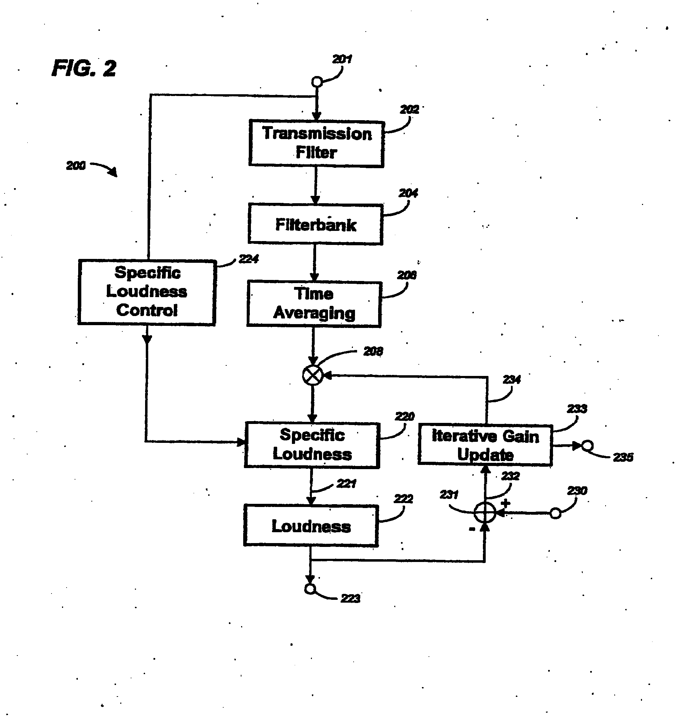

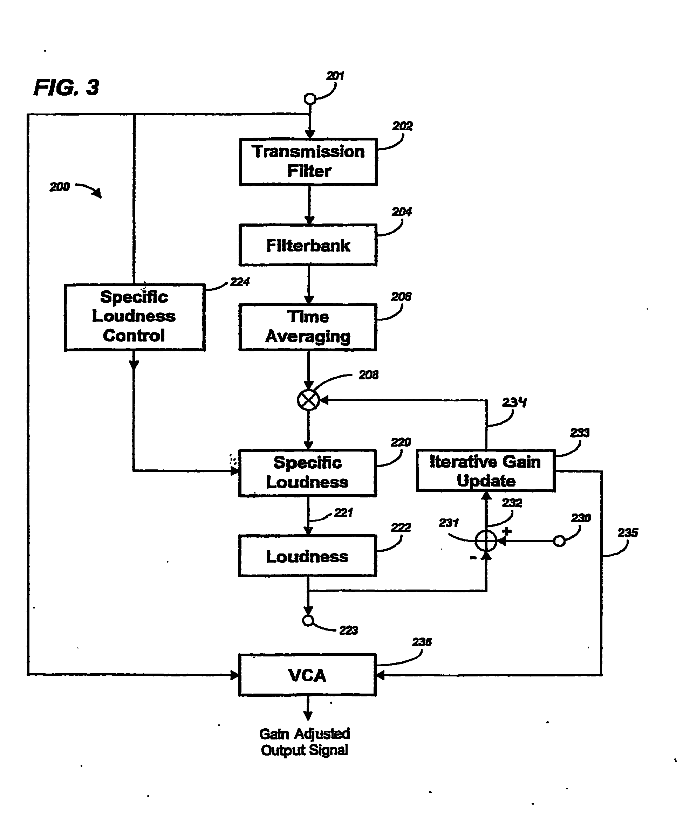

As described in greater detail below, an embodiment of a second aspect of the present invention, shown in FIG. 2, adds a gain device or function ("Iterative Gain Update") 233, the purpose of which is to adjust iteratively the gain of the time-averaged excitation signal derived from the input audio signal until the associated loudness at 223 in FIG. 2 matches a desired reference loudness at 230 in FIG. 2. Because the objective measurement of perceived loudness involves an inherently non-linear process, an iterative loop may be advantageously employed to determine an appropriate gain to match the loudness of the input audio signal to a desired loudness level. However, an iterative gain loop surrounding an entire loudness measurement system, such that the gain adjustment is applied to the original input audio signal for each loudness iteration, would be expensive to implement due to the temporal integration required to generate an accurate measure of long-term loudness. In general, in such an arrangement, the temporal integration requires recomputation for each change of gain in the iteration. However, as is explained further below, in the aspects of the invention shown in the embodiments of FIG. 2 and also FIGS. 3, and 10-12, the temporal integration may be performed in linear processing paths that precede and/or follow the non-linear process that forms part of the iterative gain loop. Linear processing paths need not form a part of the iteration loop. Thus, for example in the embodiment of FIG. 2, the loudness measurement path from input 201 to a specific loudness converter or converter function ("Specific Loudness") 220, may include the temporal integration in time averaging function ("Time Averaging") 206, and is linear. Consequently, the gain iterations need only be applied to a reduced set of loudness measurement devices or functions and need not include any temporal integration. In the embodiment of FIG. 2 the transmission filter or transmission filter function ("Transmission Filter") 202, the filter bank or filter bank function ("Filterbank") 204, the time averager or time averaging function ("Time Averaging") 206 and the specific loudness controller or specific loudness control function ("Specific Loudness Control") 224 are not part of the iterative loop, permitting iterative gain control to be implemented in efficient and accurate real-time systems.

Referring again to FIG. 1, a functional block diagram of an embodiment of a loudness measurer or loudness measuring process 100 according to a first aspect of the present invention is shown. An audio signal for which a loudness measurement is to be determined is applied to an input 101 of the loudness measurer or loudness measuring process 100. The input is applied to two paths - a first (main) path that calculates specific loudness in each of a plurality of frequency bands that simulate those of the excitation pattern generated along the basilar membrane of the inner ear and a second (side) path having a specific loudness controller that selects the specific loudness functions or models employed in the main path.

In a preferred embodiment, processing of the audio is performed in the digital domain. Accordingly, the audio input signal is denoted by the discrete time sequence $x[n]$ which has been sampled from the audio source at some sampling frequency $f_s$. It is assumed that the sequence $x[n]$ has been appropriately scaled so that the rms power of $x[n]$ in decibels given by

$$RMS_{dB} = 10\log_{10}\left(\frac{1}{L}\sum_{n=0}^{L} x^2[n]\right)$$

is equal to the sound pressure level in dB at which the audio is being auditioned by a human listener. In addition, the audio signal is assumed to be monophonic for simplicity of exposition. The embodiment may, however, be adapted to multi-channel audio in a manner described later.

Transmission Filter 102

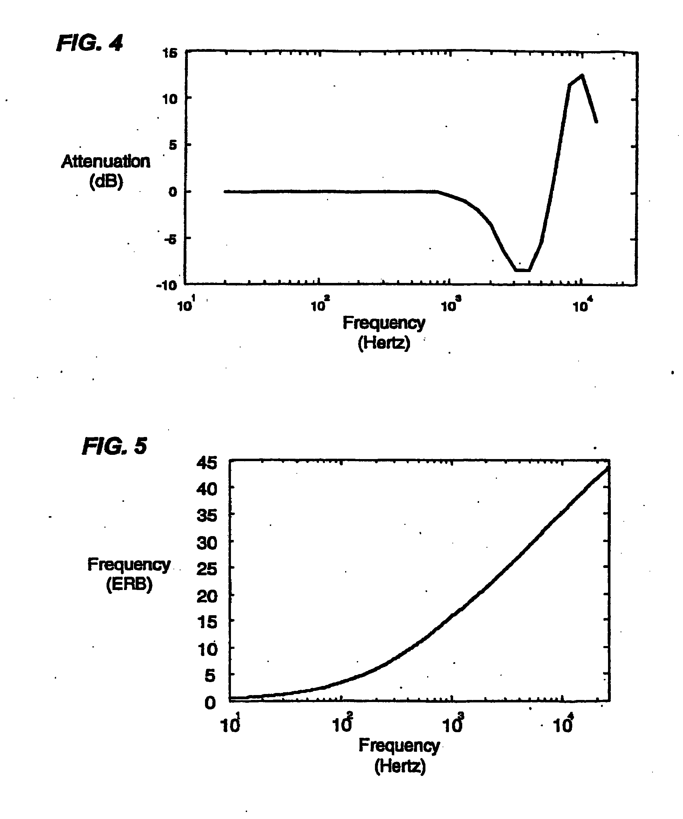

In the main path, the audio input signal is applied to a transmission filter or transmission filter function ("Transmission Filter") 102, the output of which is a filtered version of the audio signal. Transmission Filter 102 simulates the effect of the transmission of audio through the outer and middle ear with the application of a linear filter $P(z)$. As shown in FIG. 4, one suitable magnitude frequency response of $P(z)$ is unity below 1 kHz, and, above 1 kHz, the response follows the inverse of the threshold of hearing as specified in the ISO226 standard, with the threshold normalized to equal unity at 1 kHz. By applying a transmission filter, the audio that is processed by the loudness measurement process more closely resembles the audio that is perceived in human hearing, thereby improving the objective loudness measure. Thus, the output of Transmission Filter 102 is a frequency-dependently scaled version of the time-domain input audio samples $x[n]$.

Filterbank 104

The filtered audio signal is applied to a filterbank or filterbank function ("Filterbank") 104 (FIG. 1). Filterbank 104 is designed to simulate the excitation pattern generated along the basilar membrane of the inner ear. The Filterbank 104 may include a set of linear filters whose bandwidth and spacing are constant on the Equivalent Rectangular Bandwidth (ERB) frequency scale, as defined by Moore, Glasberg and Baer (B. C. J. Moore, B. Glasberg, T. Baer, "A Model for the Prediction of Thresholds, Loudness, and Partial Loudness," *supra*).

Although the ERB frequency scale more closely matches human perception and shows improved performance in producing objective loudness measurements that match subjective loudness results, the Bark frequency scale may be employed with reduced performance.

For a center frequency f in hertz, the width of one ERB band in hertz may be approximated as:

$$ERB(f) = 24.7(4.37 f/1000 + 1) \qquad (1)$$

From this relation a warped frequency scale is defined such that at any point along the warped scale, the corresponding ERB in units of the warped scale is equal to one. The function for converting from linear frequency in hertz to this ERB frequency scale is obtained by integrating the reciprocal of Equation 1:

$$HzToERB(f) = \int \frac{1}{24.7(4.37 f/1000 + 1)} df = 21.4\log_{10}(4.37 f/1000 + 1) \quad (2a)$$

It is also useful to express the transformation from the ERB scale back to the linear frequency scale by solving Equation 2a for f:

$$ERBToHz(e) = f = \frac{1000}{4.37} 10^{(e/21.4-1)}, \qquad (2b)$$

where e is in units of the ERB scale. FIG. 5 shows the relationship between the ERB scale and frequency in hertz.

The response of the auditory filters for the Filterbank 104 may be characterized and implemented using standard IIR filters. More specifically, the individual auditory filters at center frequency $f_c$ in hertz that are implemented in the Filterbank 104 may be defined by the twelfth order IIR transfer function:

$$H_{f_c}(z) = G\frac{(1-z^{-1})(1-2r_B\cos(2\pi f_B/f_s)z^{-1}+r_B^2 z^{-2})}{(1-2r_A\cos(2\pi f_A/f_s)z^{-1}+r_A z^{-2})^6}, \qquad (3)$$

where

$$f_A = \sqrt{f_c^2 + B_w^2}, \qquad (4a)$$

$$r_A = e^{-2\pi B_w/f_s}, \qquad (4b)$$

$$B_w = \min\{1.55ERB(f_c), 0.5f_c\}, \qquad (4c)$$

$$f_B = \min\{ERBscale^{-1}(ERBscale(f_c)+5.25), f_s/2\}, \qquad (4d)$$

$$r_B = 0.985, \qquad (4e)$$

$f_s$ is the sampling frequency in hertz, and $G$ is a normalizing factor to ensure that each filter has unity gain at the peak in its frequency response; chosen such that

$$\max_\omega\left\{\left|H_{f_c}(e^{j\omega})\right|\right\} = 1. \qquad (4f)$$

The Filterbank 104 may include $M$ such auditory filters, referred to as bands, at center frequencies $f_c[1]...f_c[M]$ spaced uniformly along the ERB scale. More specifically,

$$f_c[1] = f_{min} \qquad (5a)$$

$$f_c[m] = f_c[m-1] + ERBToHz(HzToERB(f_c[m-1])+\Delta) \qquad m = 2...M \quad (5b)$$

$$f_c[M] < f_{max}, \qquad (5c)$$

where $\Delta$ is the desired ERB spacing of the Filterbank 104, and where $f_{min}$ and $f_{max}$ are the desired minimum and maximum center frequencies, respectively. One may choose $\Delta = 1$, and taking into account the frequency range over which the human ear is sensitive, one may set $f_{min} = 50Hz$ and $f_{max} = 20,000Hz$. With such parameters, for example, application of Equations 6a-c yields M=40 auditory filters. The magnitudes of such M auditory filters, which approximate critical banding on the ERB scale, are shown in FIG. 6.

Alternatively, the filtering operations may be adequately approximated using a finite length Discrete Fourier Transform, commonly referred to as the Short-Time Discrete Fourier Transform (STDFT), because an implementation running the filters at the sampling rate of the audio signal, referred to as a full-rate implementation, is believed to provide more temporal resolution than is necessary for accurate loudness measurements. By using the STDFT instead of a full-rate implementation, an improvement in efficiency and reduction in computational complexity may be achieved.

The STDFT of input audio signal $x[n]$ is defined as:

$$X[k,t] = \sum_{n=0}^{N-1} w[n]x[n+tT]e^{-j\frac{2\pi nk}{N}},$$ (6)

where $k$ is the frequency index, $t$ is the time block index, $N$ is the DFT size, $T$ is the hop size, and $w[n]$ is a length $N$ window normalized so that

$$\sum_{n=0}^{N-1} w^2[n] = 1$$ (7)

Note that the variable $t$ in Equation 6 is a discrete index representing the time block of the STDFT as opposed to a measure of time in seconds. Each increment in $t$ represents a hop of $T$ samples along the signal $x[n]$. Subsequent references to the index $t$ assume this definition. While different parameter settings and window shapes may be used depending upon the details of implementation, for $f_s$ = 44100Hz, choosing $N$ = 4096, $T$ = 2048 , and having w[n] be a Hanning window produces excellent results. The STDFT described above may be more efficient using the Fast Fourier Transform (FFT).

In order to compute the loudness of the input audio signal, a measure of the audio signals' energy in each filter of the Filterbank 104 is needed. The short-time energy output of each filter in Filterbank 104 may be approximated through multiplication of filter responses in the frequency domain with the power spectrum of the input signal:

$$E[m,t] = \frac{1}{N} \sum_{k=0}^{N-1} \left| H_{f_m}(e^{j\frac{2\pi k}{N}}) \right|^2 \left| P(e^{j\frac{2\pi k}{N}}) \right|^2 |X[k,t]|^2,$$ (8)

where $m$ is the band number, $t$ is the block number, and $P$ is the transmission filter. It should be noted that forms for the magnitude response of the auditory filters other than that specified in Equation 3 may be used in Equation 8 to achieve similar results. For example, Moore and Glasberg propose a filter shape described by an exponential function that performs similarly to Equation 3. In addition, with a slight reduction in performance, one may approximate each filter as a "brick-wall" band pass with a bandwidth of one ERB, and as a further approximation, the transmission filter P may be pulled out of the summation. In this case, Equation 8 simplifies to

$$E[m,t] = \frac{1}{N} \left| P(e^{j2\pi f_c[m]/f_s}) \right|^2 \sum_{k=k_1}^{k_2} |X[k,t]|^2$$ (9a)

$$k_1 = round\left(ERBToHz(HzToERB(f_c[m]) - 1/2)N/f_s\right)$$ (9b)

$$k_2 = round\left(ERBToHz(HzToERB(f_c[m]) + 1/2)N/f_s\right)$$ (9c)

Thus, the excitation output of Filterbank 104 is a frequency domain representation of energy E in respective ERB bands m per time period $t$.

Multi-Channel

For the case when the input audio signal is of a multi-channel format to be auditioned over multiple loudspeakers, one for each channel, the excitation for each individual channel may first be computed as described above. In order to subsequently compute the perceived loudness of all channels combined, the individual excitations may be summed together into a single excitation to approximate the excitation reaching the ears of a listener. All subsequent processing is then performed on this single, summed excitation.

Time Averaging 106

Research in psychoacoustics and subjective loudness tests suggest that when comparing the loudness between various audio signals listeners perform some type of temporal integration of short-term or "instantaneous" signal loudness to arrive at a value of long-term perceived loudness for use in the comparison. When building a model of loudness perception, others have suggested that this temporal integration be performed after the excitation has been transformed non-linearly into specific loudness. However, the present inventors have determined that this temporal integration may be adequately modeled using linear smoothing on the excitation before it is transformed into specific loudness. By performing the smoothing prior to computation of specific loudness, according to an aspect of the present invention, a significant advantage is realized when computing the gain that needs to be applied to a signal in order to adjust its measured loudness in a prescribed manner. As explained further below, the gain may be calculated by using an iterative loop that not only excludes the excitation calculation but preferably excludes such temporal integration. In this manner, the iteration loop may generate the gain through computations that depend only on the current time frame for which the gain is being computed as opposed to computations that depend on the entire time interval of temporal integration. The result is a savings in both processing time and memory. Embodiments that calculate a gain using an iterative loop include those described below in connection with FIGS. 2, 3, and 10-12.

Returning to the description of FIG. 1, linear smoothing of the excitation may be implemented in various ways. For example, smoothing may be performed recursively using a time averaging device or function ("Time Averaging") 106 employing the following equations:

$$\tilde{E}[m,t] = \tilde{E}[m,t-1] + \frac{1}{\tilde{\sigma}[m,t]}\Big(E[m,t] - \tilde{E}[m,t-1]\Big) \qquad (10a)$$

$$\tilde{\sigma}[m,t] = \lambda_m \tilde{\sigma}[m,t-1] + 1, \qquad (10b)$$

where the initial conditions are $\tilde{E}[m,-1] = 0$ and $\tilde{\sigma}[m,-1] = 0$. A unique feature of the smoothing filter is that by varying the smoothing parameter $\lambda_m$, the smoothed energy $\tilde{E}[m,t]$ may vary from the true time average of $E[m,t]$ to a fading memory average of $E[m,t]$. If $\lambda_m = 1$ then from (10b) it may be seen that $\tilde{\sigma}[m,t] = t$, and $\tilde{E}[m,t]$ is then equal to the true time average of $E[m,t]$ for time blocks 0 up to $t$. If $0 \le \lambda_m < 1$ then $\tilde{\sigma}[m,t] \to 1/(1 - \lambda_m)$ as $t \to \infty$ and $\tilde{E}[m,t]$ is simply the result of applying a one pole smoother to $E[m,t]$. For the application where a single number describing the long-term loudness of a finite length audio segment is desired, one may set $\lambda_m = 1$ for all $m$. For a real-time application where one would like to track the time-varying long-term loudness of a continuous audio stream in real-time, one may set $0 \le \lambda_m < 1$ and set $\lambda_m$ to the same value for all m.

In computing the time-average of $E[m,t]$, it may be desirable to omit short-time segments that are considered "too quiet" and do not contribute to the perceived loudness. To achieve this, a second thresholded smoother may be run in parallel with the smoother in Equation 10. This second smoother holds its current value if $E[m,t]$ is small relative to $\tilde{E}[m,t]$:

$$\bar{E}[m,t] = \begin{cases} \bar{E}[m,t-1] + \frac{1}{\tilde{\sigma}[m,t]}\Big(E[m,t] - \bar{E}[m,t-1]\Big), & \sum_{m=1}^{M} E[m,t] > 10^{\frac{tdB}{10}} \sum_{m=1}^{M} \tilde{E}[m,t] \\ \bar{E}[m,t-1], & otherwise \end{cases} \qquad (11a)$$

$$\overline{\sigma}[m,t] = \begin{cases} \lambda_m \overline{\sigma}[m,t-1]+1, & \sum_{m=1}^{M} E[m,t] > 10^{\frac{tdB}{10}} \sum_{m=1}^{M} \widetilde{E}[m,t] \\ \overline{\sigma}[m,t-1], & otherwise \end{cases} \qquad (11b)$$

where *tdB* is the relative threshold specified in decibels. Although it is not critical to the invention, a value of *tdB* = -24 has been found to produce good results. If there is no second smoother running in parallel, then $\overline{E}[m,t] = \widetilde{E}[m,t]$.

Specific Loudness 120

It remains for the banded time-averaged excitation energy $\overline{E}[m,t]$ to be converted into a single measure of loudness in perceptual units, sone in this case. In the specific loudness converter or conversion function ("Specific Loudness") 120, each band of the excitation is converted into a value of specific loudness, which is measured in sone per ERB. In the loudness combiner or loudness combining function ("Loudness") 122, the values of specific loudness may be integrated or summed across bands to produce the total perceptual loudness.

Specific Loudness Control 124 / Specific Loudness 120

Multiple Models

In one aspect, the present invention utilizes a plurality of models in block 120 for converting banded excitation to banded specific loudness. Control information derived from the input audio signal via Specific Loudness Control 124 in the side path selects a model or controls the degree to which a model contributes to the specific loudness. In block 124, certain features or characteristics that are useful for selecting one or more specific loudness models from those available are extracted from the audio. Control signals that indicate which model, or combinations of models, should be used are generated from the extracted features or characteristics. Where it may be desirable to use more than one model, the control information may also indicate how such models should be combined.

For example, the per band specific loudness $N'[m,t]$ may be expressed as a linear combination of the per band specific loudness for each model $N''[m,t]$ as:

$$N'[m,t] = \sum_{q=1}^{Q} \alpha_q[m,t] N_q'[m,t], \qquad (12)$$

where $Q$ indicates the total number of models and the control information $\alpha_q[m,t]$ represents the weighting or contribution of each model. The sum of the weightings may or may not equal one, depending on the models being used.

Although the invention is not limited to them, two models have been found to give accurate results. One model performs best when the audio signal is characterized as narrowband, and the other performs best when the audio signal is characterized as wideband.

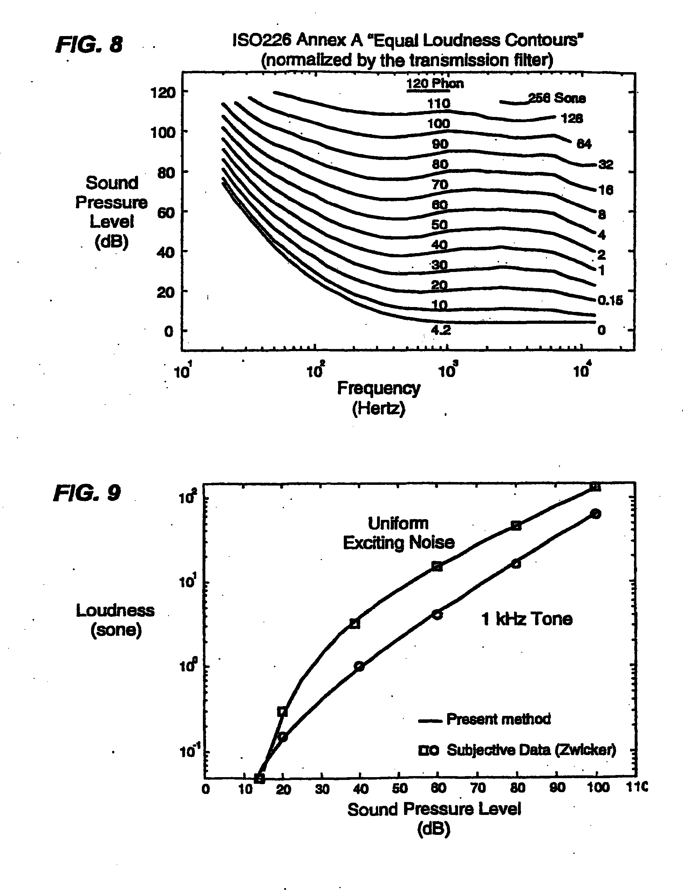

Initially, in computing specific loudness, the excitation level in each band of $E[m,t]$ may be transformed to an equivalent excitation level at 1 kHz as specified by the equal loudness contours of ISO266 (FIG. 7) normalized by the transmission filter P(z) (FIG. 8):

$$\overline{E}_{1kHz}[m,t] = L_{1kHz}(\overline{E}[m,t], f_c[m]), \qquad (13)$$

where $L_{1kHz}(E,f)$ is a function that generates the level at 1 kHz, which is equally loud to level $E$ at frequency $f$. In practice, $L_{1kHz}(E,f)$ is implemented as an interpolation of a look-up table of the equal loudness contours, normalized by the transmission filter. Transformation to equivalent levels at 1 kHz simplifies the following specific loudness calculation.

Next, the specific loudness in each band may be computed as:

$$N'[m,t] = \alpha[m,t]N'_{NB}[m,t] + (1-\alpha[m,t])N'_{WB}[m,t], \qquad (14)$$

where $N'_{NB}[m,t]$ and $N'_{WB}[m,t]$ are specific loudness values based on a narrowband and wideband signal model, respectively. The value $\alpha[m, t]$ is an interpolation factor lying between 0 and 1 that is computed from the audio signal, the details of which are described below.

The narrowband and wideband specific loudness values $N'_{NB}[m,t]$ and $N'_{WB}[m,t]$ may be estimated from the banded excitation using the exponential functions:

$$N'_{NB}[m,t] = \begin{cases} G_{NB}\left(\left(\dfrac{\overline{E}_{1kHz}[m,t]}{TQ_{1kHz}}\right)^{\beta_{NB}} - 1\right), & \overline{E}_{1kHz}[m,t] > 10^{\frac{TQ_{1kHz}}{10}} \\ 0, & \text{otherwise} \end{cases} \qquad (15a)$$

$$N'_{WB}[m,t] = \begin{cases} G_{WB}\left(\left(\dfrac{\overline{E}_{1kHz}[m,t]}{TQ_{1kHz}}\right)^{\beta_{WB}} - 1\right), & \overline{E}_{1kHz}[m,t] > 10^{\frac{TQ_{1kHz}}{10}} \\ 0, & \text{otherwise} \end{cases} \qquad (15b)$$

where $TQ_{1kHz}$ is the excitation level at threshold in quiet for a 1 kHz tone. From the equal loudness contours (FIGS. 7 and 8) $TQ_{1kHz}$ equals 4.2 dB. One notes that both of these specific loudness functions are equal to zero when the excitation is equal to the threshold in quiet. For excitations greater than the threshold in quiet, both functions grow monotonically with a power law in accordance with Stevens' law of intensity sensation. The exponent for the narrowband function is chosen to be larger than that of the wideband function, making the narrowband function increase more rapidly than the wideband function. The specific selection of exponents $\beta$ and gains $G$ for the narrowband and wideband cases and are discussed below.

Loudness 122

Loudness 122 uses the banded specific loudness of Specific Loudness 120 to create a single loudness measure for the audio signal, namely an output at terminal 123 that is a loudness value in perceptual units. The loudness measure may have arbitrary units, as long the comparison of loudness values for different audio signals indicates which is louder and which is softer.

The total loudness expressed in units of sone may be computed as the sum of the specific loudness for all frequency bands:

$$S[t] = \Delta \sum_{m=1}^{M} N'[m,t], \qquad (16)$$

where $\Delta$ is the ERB spacing specified in Equation 6b. The parameters $G_{NB}$ and $\beta_{NB}$ in Equation 15a are chosen so that when $\alpha[m,t] = 1$, a plot of S in sone versus SPL for a 1 kHz tone substantially matches the corresponding experimental data presented by Zwicker (the circles in FIG. 9) (Zwicker, H. Fastl, "Psychoacoustics - Facts and Models," supra). The parameters $G_{WB}$ and $\beta_{WB}$ in Equation 15b are chosen so that when $\alpha[m,t] = 0$, a plot of N in sone versus SPL for uniform exciting noise (noise with equal power in each ERB) substantially matches the corresponding results from Zwicker (the squares in FIG. 9). A least squares fit to Zwicker's data yields:

$$G_{NB} = 0.0404 \qquad (17a)$$

$$\beta_{NB} = 0.279 \qquad (17b)$$

$$G_{WB} = 0.058 \qquad (17c)$$

$$\beta_{NB} = 0.212 \qquad (17d)$$

FIG. 9 (solid lines) shows plots of loudness for both uniform-exciting noise and a 1 kHz tone.

Specific Loudness Control 124

As previously mentioned, two models of specific loudness are used in a practical embodiment (Equations 15a and 15b), one for narrowband and one for wideband signals. Specific Loudness Control 124 in the side path calculates a measure, $\alpha[m,t]$, of the degree to which the input signal is either narrowband or wideband in each band. In a general sense, $\alpha[m,t]$ should equal one when the signal is narrowband near the center frequency $f_c[m]$ of a band and zero when the signal is wideband near the center frequency $f_c[m]$ of a band. The control should vary continuously between the two extremes for varying mixtures of such features. As a simplification, the control $\alpha[m,t]$ may be chosen as constant across the bands, in which case $\alpha[m,t]$ is subsequently referred to as $\alpha[t]$, omitting the band index $m$. The control $\alpha[t]$ then represents a measure of how narrowband the signal is across all bands. Although a suitable method for generating such a control is described next, the particular method is not critical and other suitable methods may be employed.

The control $\alpha[t]$ may be computed from the excitation $E[m,t]$ at the output of Filterbank 104 rather than through some other processing of the signal $x[n]$. $E[m,t]$ may provide an adequate reference from which the "narrowbandedness" and "widebandedness" of $x[n]$ is measured, and as a result, $\alpha[t]$ may be generated with little added computation.

"Spectral flatness" is a feature of $E[m,t]$ from which $\alpha[t]$ may be computed. Spectral flatness, as defined by Jayant and Noll (N. S. Jayant, P. Noll, Digital Coding Of Waveforms, Prentice Hall, New Jersey, 1984), is the ratio of the geometric mean to the arithmetic mean, where the mean is taken across frequency (index m in the case of $E[m,t]$). When $E[m,t]$ is constant across m, the geometric mean is equal to the arithmetic mean, and the spectral flatness equals one. This corresponds to the wideband case. If $E[m,t]$ varies significantly across $m$, then the geometric mean is significantly smaller than the arithmetic mean, and the spectral flatness approaches zero. This corresponds to the narrowband case. By computing one minus the spectral flatness, one may generate a measure of "narrowbandedness," where zero corresponds to wideband and one to narrowband. Specifically, one may compute one minus a modified spectral flatness of $E[m,t]$:

$$NB[t] = 1 - \frac{\left( \prod_{m=M_l[t]}^{M_u[t]} \frac{E[m,t]}{|P[m]|^2} \right)^{\frac{1}{M_u[t]-M_l[t]+1}}}{\frac{1}{M_u[t]-M_l[t]+1} \sum_{m=M_l[t]}^{M_u[t]} \frac{E[m,t]}{|P[m]|^2}}, \qquad (18)$$

where $P[m]$ is equal to the frequency response of the transmission filter $P(z)$ sampled at frequency $\omega = 2\pi f_c[m]/f_s$. Normalization of $E[m,t]$ by the transmission filter may provide better results because application of the transmission filter introduces a "bump" in $E[m,t]$ that tends to inflate the "narrowbandedness" measure. Additionally, computing the spectral flatness over a subset of the bands of $E[m,t]$ may yield better results. The lower and upper limits of summation in Equation 18, $M_l[t]$ and $M_u[t]$, define a region that may be smaller than the range of all $M$ bands. It is desired that $M_l[t]$ and $M_u[t]$ include the portion of $E[m,t]$ that contains the majority of its energy, and that the range defined by $M_l[t]$ and $M_u[t]$ be no more than 24 units wide on the ERB scale. More specifically (and recalling that $f_c[m]$ is the center frequency of band $m$ in Hz), one desires:

$$HzToERB(f_c[M_u[t]]) - HzToERB(f_c[M_l[t]]) \cong 24 \qquad (19a)$$

and one requires:

$$HzToERB(f_c[M_u[t]]) \geq CT[t] \geq HzToERB(f_c[M_l[t]]) \qquad (19b)$$

$$HzToERB(f_c[M_l[t]]) \geq HzToERB(f_c[1]) \qquad (19c)$$

$$HzToERB(f_c[M_u[t]]) \leq HzToERB(f_c[M]), \qquad (19d)$$

where $CT[t]$ is the spectral centroid of $E[m,t]$ measured on the ERB scale:

$$CT[t] = \frac{\sum_{m=1}^{M} HzToERB(f_c[m]) E[m,t]}{\sum_{m=1}^{M} E[m,t]}, \qquad (19e)$$

Ideally, the limits of summation, $M_l[t]$ and $M_u[t]$, are centered around $CT[t]$ when measured on the ERB scale, but this is not always possible when $CT[t]$ is near the lower or upper limits of its range.

Next, $NB[t]$ may be smoothed over time in a manner analogous to Equation 11a:

$$\overline{NB}[t] = \begin{cases} \overline{NB}[t-1] + \dfrac{1}{\overline{\sigma}[t]} \left( NB[t] - \overline{NB}[t-1] \right), & \sum_{m=1}^{M} E[m,t] > 10^{\frac{tdB}{10}} \sum_{m=1}^{M} \tilde{E}[m,t] \\ \overline{NB}[t-1], & otherwise \end{cases} , \qquad (20)$$

where $\overline{\sigma}[t]$ is equal to the maximum of $\ddot{\sigma}[m,t]$, defined in Equation 11b, over all $m$. Lastly, $\alpha[t]$ is computed from $\overline{NB}[t]$ as follows:

$$\alpha[t] = \begin{cases} 0, & \Phi\{\overline{NB}[t]\} < 0 \\ \Phi\{\overline{NB}[t]\}, & 0 \leq \Phi\{\overline{NB}[t]\} \leq 1 \\ 1, & \Phi\{\overline{NB}[t]\} \geq 1 \end{cases} , \qquad (21a)$$

where

$$\Phi\{x\} = 12.2568x^3 - 22.8320x^2 + 14.5869x - 2.9594 \qquad (21b)$$

Although the exact form of $\Phi\{x\}$ is not critical, the polynomial in Equation 21b may be found by optimizing $\alpha[t]$ against the subjectively measured loudness of a large variety of audio material.

FIG. 2 shows a functional block diagram of an embodiment of a loudness measurer or loudness measuring process 200 according to a second aspect of the present invention. Devices or functions 202, 204, 206, 220, 222, 223 and 224 of FIG. 2 correspond to the respective devices or functions 102, 104, 106, 120, 122, 123 and 124 of FIG. 1.

According to the first aspect of the invention, of which FIG. 1 shows an embodiment, the loudness measurer or computation generates a loudness value in perceptual units. In order to adjust the loudness of the input signal, a useful measure is a gain $G[t]$, which when multiplied with the input signal $x[n]$ (as, for example, in the embodiment of FIG. 3, described below), makes its loudness equal to a reference loudness level $S_{ref}$. The reference loudness, $S_{ref}$, may be specified arbitrarily or measured by another device or process operating in accordance with the first aspect of the invention from some "known" reference audio signal. Letting $\Psi\{x[n],t\}$ represent all the computation performed on signal $x[n]$ to generate loudness $S[t]$, one wants to find $G[t]$ such that

$$S_{ref} = S[t] = \Psi\{G[t]x[n],t\} \tag{23}$$

Because a portion of the processing embodied in $\Psi\{\cdot\}$ is non-linear, no closed form solution for $G[t]$ exists, so instead an iterative technique may be utilized to find an approximate solution. At each iteration $i$ in the process, let $G_i$ represent the current estimate of $G[t]$. For every iteration, $G_i$ is updated so that the absolute error from the reference loudness decreases:

$$\left|S_{ref} - \Psi\{G_i x[n],t\}\right| < \left|S_{ref} - \Psi\{G_{i-1} x[n],t\}\right| \tag{24}$$

There exist many suitable techniques for updating $G_i$ in order to achieve the above decrease in error. One such method is gradient descent (see Nonlinear Programming by Dimitri P. Bertseakas, Athena Scientific, Belmont, MA 1995) in which $G_i$ is updated by an amount proportional to the error at the previous iteration:

$$G_i = G_{i-1} + \mu(S_{ref} - \Psi\{G_{i-1}x[n],t\}), \tag{25}$$

where $\mu$ is the step size of the iteration. The above iteration continues until the absolute error is below some threshold, until the number of iterations has reached some predefined maximum limit, or until a specified time has passed. At that point $G[t]$ is set equal to $G_i$.

Referring back to Equations 6-8, one notes that the excitation of the signal $x[n]$ is obtained through linear operations on the square of the signal's STDFT magnitude, $|X[k,t]|^2$. It follows that the excitation resulting from a gain-modified signal $Gx[n]$ is equal to the excitation of $x[n]$ multiplied by $G^2$. Furthermore, the temporal integration required to estimate long-term perceived loudness may be performed through linear time-averaging of the excitation, and therefore the time-averaged excitation corresponding to $Gx[n]$ is equal to the time-averaged excitation of $x[n]$ multiplied by $G^2$. As a result, the time averaging need not be recomputed over the entire input signal history for every re-evaluation of $\Psi\{G_i x[n],t\}$ in the iterative process described above. Instead, the time-averaged excitation $\overline{E}[m, t]$ may be computed only once from $x[n]$, and, in the iteration, updated values of loudness may be computed by applying the square of the updated gain directly to $\overline{E}[m, t]$ Specifically, letting $\Psi_E\{\overline{E}[m, t]\}$ represent all the processing performed on the time averaged excitation $\overline{E}[m, t]$ to generate $S[t]$, the following relationship holds for a general multiplicative gain $G$:

$$\Psi_E\{G^2\overline{E}[m,t]\} = \Psi\{Gx[n],t\} \tag{26}$$

Using this relationship, the iterative process may be simplified by replacing $\Psi\{G_i x[n],t\}$ with $\Psi_E\{G_i^2 \overline{E}[m,t]\}$. This simplification would not be possible had the temporal integration required to estimate long-term perceived loudness been performed after the non-linear transformation to specific loudness.

The iterative process for computing $G[t]$ is depicted in FIG.2. The output loudness $S[t]$ at terminal 223 may be subtracted in a subtractive combiner or combining function 231 from reference loudness $S_{ref}$ at terminal 230. The resulting error signal 232 is fed into an iterative gain updater or updating function ("Iterative Gain Update") 233 that generates

the next gain $G_i$ in the iteration. The square of this gain, $G_i^2$, is then fed back at output 234 to multiplicative combiner 208 where $G_i^2$ is multiplied with the time-averaged excitation signal from block 206. The next value of $S[t]$ in the iteration is then computed from this gain-modified version of the time-averaged excitation through blocks 220 and 222. The described loop iterates until the termination conditions are met at which time the gain $G[t]$ at terminal 235 is set equal to the current value of $G_i$. The final value $G[t]$ may be computed through the described iterative process, for example, for every FFT frame $t$ or just once at the end of an audio segment after the excitation has been averaged over the entire length of this segment.

If one wishes to compute the non-gain-modified signal loudness in conjunction with this iterative process, the gain $G_i$ can be initialize to one at the beginning of each iterative process for each time period $t$. This way, the first value of $S[t]$ computed in the loop represents the original signal loudness and can be recorded as such. If one does not wish to record this value, however, $G_i$ may be initialized with any value. In the case when $G[t]$ is computed over consecutive time frames and one does not wish to record the original signal loudness, it may be desirable to initialize $G_i$ equal to the value of $G[t]$ from the previous time period. This way, if the signal has not changed significantly from the previous time period, it likely that the value $G[t]$ will have remained substantially the same. Therefore, only a few iterations will be required to converge to the proper value.

Once the iterations are complete, $G[t]$ represents the gain to be applied to the input audio signal at 201 by some external device such that the loudness of the modified signal matches the reference loudness. FIG. 3 shows one suitable arrangement in which the gain $G[t]$ from the Iterative Gain Update 233 is applied to a control input of a signal level controlling device or function such as a voltage controlled amplifier (VCA) 236 in order to provide a gain adjusted output signal. VCA 234 in FIG. 3 may be replaced by a human operator controlling a gain adjuster in response to a sensory indication of the gain $G[t]$ on line 235. A sensory indication may be provided by a meter, for example. The gain $G[t]$ may be subject to time smoothing (not shown).

For some signals, an alternative to the smoothing described in Equations 10 and 11 may be desirable for computing the long-term perceived loudness. Listeners tend to associate the long-term loudness of a signal with the loudest portions of that signal. As a result, the smoothing presented in Equations 10 and 11 may underestimate the perceived loudness of a signal containing long periods of relative silence interrupted by shorter segments of louder material. Such signals are often found in film sound tracks with short segments of dialog surrounded by longer periods of ambient scene noise. Even with the thresholding presented in Equation 11, the quiet portions of such signals may contribute too heavily to the time-averaged excitation $\bar{E}[m, t]$.

To deal with this problem, a statistical technique for computing the long-term loudness may be employed in a further aspect of the present invention. First, the smoothing time constant in Equations 10 and 11 is made very small and $tdB$ is set to minus infinity so that $\bar{E}[m, t]$ represents the "instantaneous" excitation. In this case, the smoothing parameter $\lambda_m$ may be chosen to vary across the bands $m$ to more accurately model the manner in which perception of instantaneous loudness varies across frequency. In practice, however, choosing $\lambda_m$ to be constant across $m$ still yields acceptable results. The remainder of the previously described algorithm operates unchanged resulting in an instantaneous loudness signal $S[t]$, as specified in Equation 16. Over some range $t_1 \leq t \leq t_2$ the long-term loudness $S_p[t_1,t_2]$ is then defined as a value which is greater than $S[t]$ for $p$ percent of the time values in the range and less than $S[t]$ for 100-$p$ percent of the time values in the range. Experiments have shown that setting $p$ equal to roughly 90% matches subjectively perceived long-term loudness. With this setting, only 10% of the values of $S[t]$ need be significant to affect the long-term loudness. The other 90% of the values can be relatively silent without lowering the long-term loudness measure.

The value $S_p[t_1,t_2]$ can be computed by sorting in ascending order the values $S[t]$, $t_1 \leq t \leq t_2$, into a list $S_{sort}\{i\}$, $0 \leq i \leq t_2 - t_1$, where $i$ represents the ith element of the sorted list. The long-term loudness is then given by the element that is $p$ percent of the way into the list:

$$S_p[t_1,t_2] = S_{sort}\{round(p(t_2 - t_1)/100)\} \qquad (27)$$

By itself, the above computation is relatively straightforward. However, if one wishes to compute a gain $G_p[t_1,t_2]$ which when multiplied with $x[n]$ results in $S_p[t_1,t_2]$ being equal to some reference loudness $S_{ref}$, the computation becomes significantly more complex. As before, an iterative approach is required, but now the long-term loudness measure $S_p[t_1,t_2]$ is dependent on the entire range of values $S[t]$, $t_1 \leq t \leq t_2$, each of which must be updated with each update of $G_i$ in the iteration. In order to compute these updates, the signal $\bar{E}[m, t]$ must be stored over the entire range $t_1 \leq t \leq t_2$. In addition, since the dependence of $S[t]$ on $G_i$ is non-linear, the relative ordering of $S[t]$, $t_1 \leq t \leq t_2$, may change with each

iteration, and therefore $S_{sort}\{i\}$ must also be recomputed. The need for re-sorting is readily evident when considering short-time signal segments whose spectrum is just below the threshold of hearing for a particular gain in the iteration. When the gain is increased, a significant portion of the segment's spectrum may become audible, which may make the total loudness of the segment greater than other narrowband segments of the signal which were previously audible. When the range $t_1 \leq t \leq t_2$ becomes large or if one desires to compute the gain $G_p[t_1,t_2]$ continuously as a function of a sliding time window, the computational and memory costs of this iterative process may become prohibitive.

A significant savings in computation and memory is achieved by realizing that $S[t]$ is a monotonically increasing function of $G_i$. In other words, increasing $G_i$ always increases the short-term loudness at each time instant. With this knowledge, the desired matching gain $G_p[t_1,t_2]$ can be efficiently computed as follows. First, compute the previously defined matching gain $G[t]$ from $\overline{E}[m, t]$ using the described iteration for all values of $t$ in the range $t_1 \leq t \leq t_2$. Note that for each value $t$, $G[t]$ is computed by iterating on the single value $\overline{E}[m, t]$. Next, the long term matching gain $G_p[t_1,t_2]$ is computed by sorting into ascending order the values $G[t]$, $t_1 \leq t \leq t_2$, into a list $G_{sort}\{i\}$, $0 \leq i \leq t_2 - t_1$, and then setting

$$G_p[t_1,t_2] = G_{sort}\{round((100 - P)(t_2 - t_1)/100)\}. \tag{28}$$

We now argue that $G_p[t_1,t_2]$ is equal to the gain which when multiplied with $x[n]$ results in $S_p[t_1,t_2]$ being equal to the desired reference loudness $S_{ref}$. Note from Equation 28 that $G[t] < Gp[t_1,t_2]$ for 100-$p$ percent of the time values in the range $t_1 \leq t \leq t_2$ and that $G[t] > G_p[t_1,t_2]$ for the other $p$ percent. For those values of $G[t]$ such that $G[t] < G_p[t_1,t_2]$, one notes that if $G_p[t_1,t_2]$ were to be applied to the corresponding values of $\overline{E}[m, t]$ rather than $G[t]$, then the resulting values of $S[t]$ would be greater than the desired reference loudness. This is true because S[t] is a monotonically increasing function of the gain. Similarly, if $G_p[t_1,t_2]$ were to be applied to the values of $\overline{E}[m, t]$ corresponding to $G[t]$ such that $G[t] > G_p[t_1,t_2]$, the resulting values of $S[t]$ would be less than the desired reference loudness. Therefore, application of $G_p[t_1,t_2]$ to all values of $E[m,t]$ in the range $t_1 \leq t \leq t_2$ results in $S[t]$ being greater than the desired reference 100-$p$ percent of the time and less than the reference $p$ percent of the time. In other words, $S_p[t_1,t_2]$ equals the desired reference.

This alternate method of computing the matching gain obviates the need to store $\overline{E}[m, t]$ and $S[t]$ over the range $t_1 \leq t \leq t_2$. Only $G[t]$ need be stored. In addition, for every value of $G_p[t_1,t_2]$ that is computed, the sorting of $G[t]$ over the range $t_1 \leq t \leq t_2$ need only be performed once, as opposed to the previous approach where S[t] needs to be re-sorted with every iteration. In the case where $G_p[t_1,t_2]$ is to be computed continuously over some length $T$ sliding window (i.e., $t_1 = t - T$, $t_2 = t$), the list $G_{sort}\{i\}$ can be maintained efficiently by simply removing and adding a single value from the sorted list for each new time instance. When the range $t_1 \leq t \leq t_2$ becomes extremely large (the length of entire song or film, for example), the memory required to store $G[t]$ may still be prohibitive. In this case, $G_p[t_1,t_2]$ may be approximated from a discretized histogram of $G[t]$. In practice, this histogram is created from $G[t]$ in units of decibels. The histogram may be computed as

$H[i]$ = number of samples in the range $t_1 \leq t \leq t_2$ such that

$$\Delta_{dB} i + dB_{min} \leq 20 \log_{10} G[t] < \Delta_{dB}(i+1) + dB_{min} \tag{29}$$

where $\Delta_{dB}$ is the histogram resolution and $dB_{min}$ is the histogram minimum. The matching gain is then approximated as

$$G_p[t_1,t_2] \cong \Delta_{dB} i_p + dB_{min} \tag{30a}$$

where

$$100 \frac{\sum_{i=0}^{i_p} H[i]}{\sum_{i=0}^{I} H[i]} \cong p. \tag{30b}$$

and $I$ is the maximum histogram index. Using the discretized histogram, only $I$ values need be stored, and $G_p[t_1,t_2]$ is

easily updated with each new value of $G[t]$.

Other methods for approximating $G_p[t_1,t_2]$ from $G[t]$ may be conceived, and this invention is intended to include such techniques. The key aspect of this portion of the invention is to perform some type of smoothing on the matching gain $G[t]$ to generate the long term matching gain $G_p[t_1,t_2]$ rather than processing the instantaneous loudness $S[t]$ to generate the long term loudness $S_p[t_1,t_2]$ from which $G_p[t_1,t_2]$ is then estimated through an iterative process.

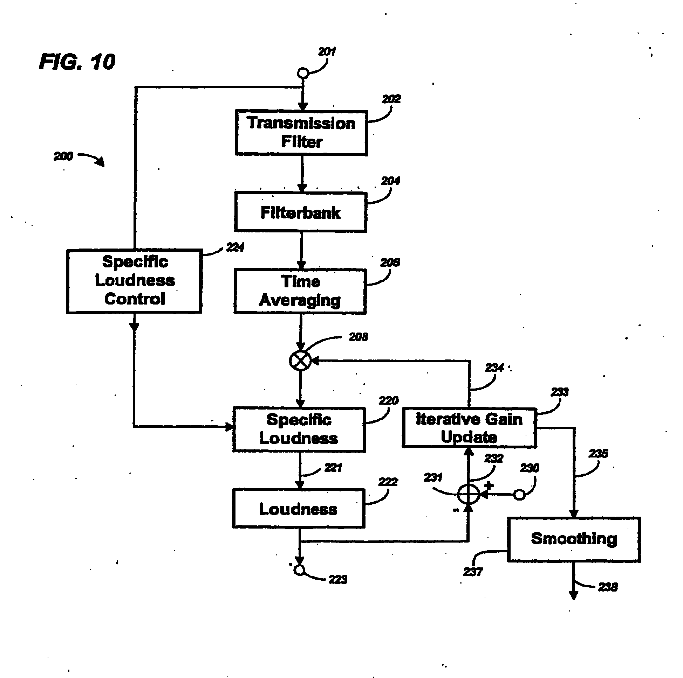

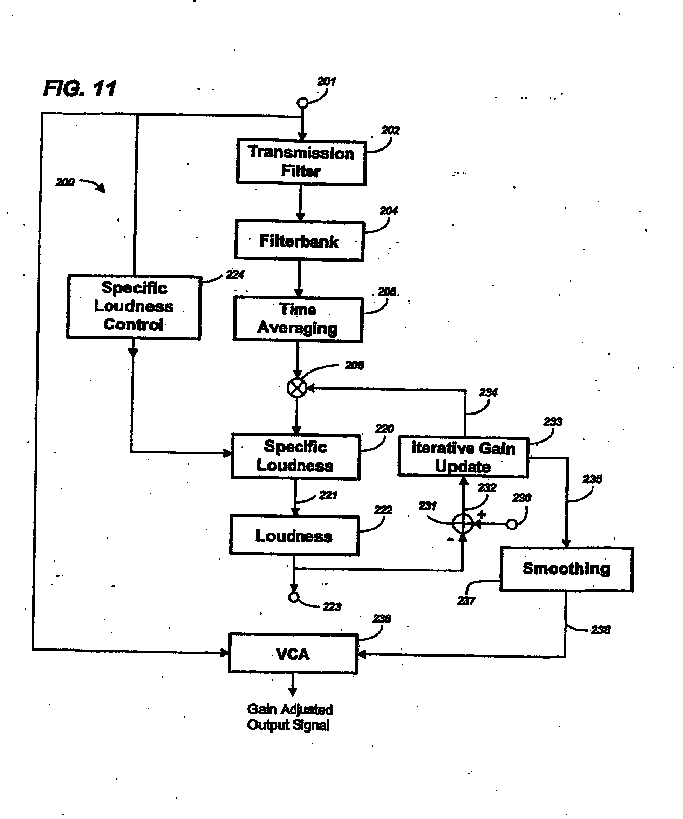

Figures 10 and 11 display systems similar to Figures 2 and 3, respectively, but where smoothing (device or function 237) of the matching gain $G[t]$ is used to generate a smoothed gain signal $G_p[t_1,t_2]$ (signal 238).

The reference loudness at input 230 (FIGS. 2, 3, 10, 11) may be "fixed" or "variable" and the source of the reference loudness may be internal or external to an arrangement embodying aspects of the invention. For example, the reference loudness may be set by a user, in which case its source is external and it may remain "fixed" for a period of time until it is re-set by the user. Alternatively, the reference loudness may be a measure of loudness of another audio source derived from a loudness measuring process or device according to the present invention, such as the arrangement shown in the example of FIG. 1.

The normal volume control of an audio-producing device may be replaced by a process or device in accordance with aspects of the invention, such as the examples of FIG. 3 or FIG. 11. In that case, the user-operated volume knob, slider, etc. would control the reference loudness at 230 of FIG. 3 or FIG. 11 and, consequently, the audio-producing device would have a loudness commensurate with the user's adjustment of the volume control.

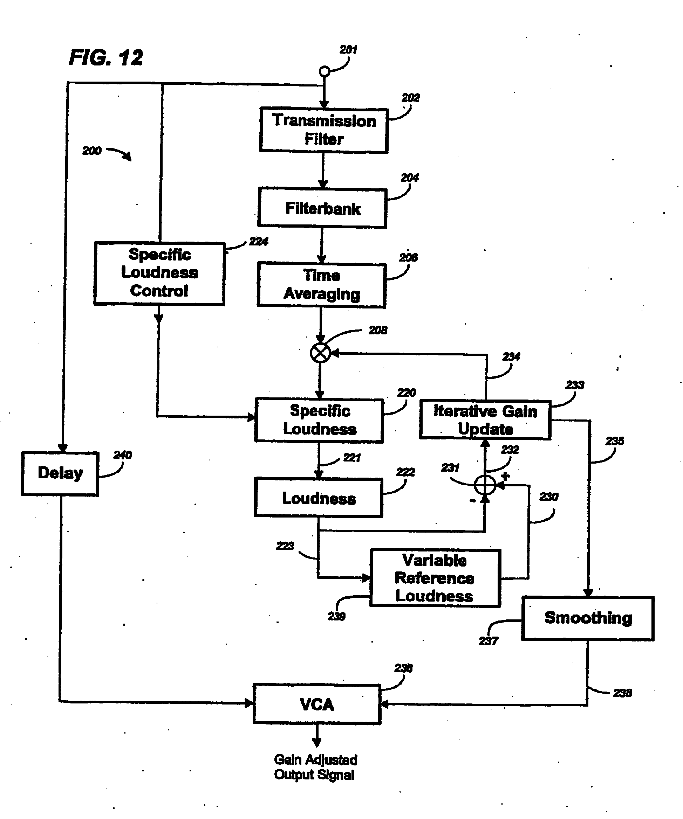

An example of a variable reference is shown in FIG. 12 where the reference loudness $S_{ref}$ is replaced by a variable reference $S_{ref}[t]$ that is computed, for example, from the loudness signal $S[t]$ through a variable reference loudness device or function ("Variable Reference Loudness") 239. In this arrangement, at the beginning of each iteration for each time period $t$, the variable reference $S_{ref}[t]$ may be computed from the unmodified loudness $S[t]$ before any gain has been applied to the excitation at 208. The dependence of $S_{ref}[t]$ and $S[t]$ through variable loudness reference function 239 may take various forms to achieve various effects. For example, the function may simply scale $S[t]$ to generate a reference that is some fixed ratio of the original loudness. Alternatively, the function might produce a reference greater than $S[t]$ when $S[t]$ is below some threshold and less than $S[t]$ when $S[t]$ is above some threshold, thus reducing the dynamic range of the perceived loudness of the audio. Whatever the form of this function, the previously described iteration is performed to compute $G[t]$ such that

$$\Psi_E\left\{G^2[t]\overline{E}[m,t]\right\} = S_{ref}[t] \tag{31}$$

The matching gain $G[t]$ may then be smoothed as described above or through some other suitable technique to achieve the desired perceptual effect. Finally, a delay 240 between the audio signal 201 and VCA block 236 may be introduced to compensate for any latency in the computation of the smoothed gain. Such a delay may also be provided in the arrangements of FIGS. 3 and 11.

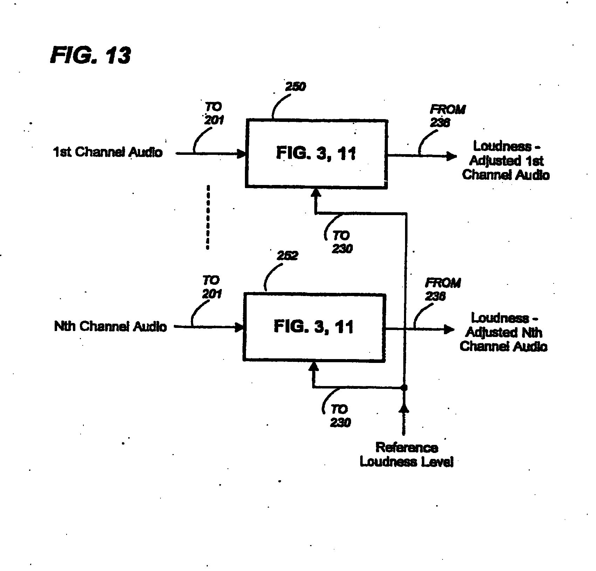

The gain control signal $G[t]$ of the FIG. 3 arrangement and the smoothed gain control signal $G_p[t_1,t_2]$ of the FIG. 11 arrangement may be useful in a variety of applications including, for example, broadcast television or satellite radio where the perceived loudness across different channels varies. In such environments, the apparatus or method of the present invention may compare the audio signal from each channel with a reference loudness level (or the loudness of a reference signal). An operator or an automated device may use the gain to adjust the loudness of each channel. All channels would thus have substantially the same perceived loudness. FIG. 13 shows an example of such an arrangement in which the audio from a plurality of television or audio channels, 1 through N, are applied to the respective inputs 201 of a processes or devices 250, 252, each being in accordance with aspects of the invention as shown in FIGS. 3 or 11. The same reference loudness level is applied to each of the processes or devices 250, 252 resulting in loudness-adjusted 1st channel through Nth channel audio at each output 236.

The measurement and gain adjustment technique may also be applied to a real-time measurement device that monitors input audio material, performs processing that identifies audio content primarily containing human speech signals, and computes a gain such that the speech signals substantially matches a previously defined reference level. Suitable techniques for identifying speech in audio material are set forth in U.S. Patent Application S.N. 10/233,073, filed August 30, 2002 and published as U.S. Patent Application Publication US 2004/0044525 A1, published March 4, 2004. . Because audience annoyance with loud audio content tends to be focused on the speech portions of program material, a measurement and gain adjustment method may greatly reduce annoying level difference in audio commonly used in television, film and music material.

*Implementation*

The invention may be implemented in hardware or software, or a combination of both (e.g., programmable logic arrays). Unless otherwise specified, the algorithms included as part of the invention are not inherently related to any particular computer or other apparatus. In particular, various general-purpose machines may be used with programs written in accordance with the teachings herein, or it may be more convenient to construct more specialized apparatus (e.g., integrated circuits) to perform the required method steps. Thus, the invention may be implemented in one or more computer programs executing on one or more programmable computer systems each comprising at least one processor, at least one data storage system (including volatile and non-volatile memory and/or storage elements), at least one input device or port, and at least one output device or port. Program code is applied to input data to perform the functions described herein and generate output information. The output information is applied to one or more output devices, in known fashion.

Each such program may be implemented in any desired computer language (including machine, assembly, or high level procedural, logical, or object oriented programming languages) to communicate with a computer system. In any case, the language may be a compiled or interpreted language.

Each such computer program is preferably stored on or downloaded to a storage media or device (e.g., solid state memory or media, or magnetic or optical media) readable by a general or special purpose programmable computer, for configuring and operating the computer when the storage media or device is read by the computer system to perform the procedures described herein. The inventive system may also be considered to be implemented as a computer-readable storage medium, configured with a computer program, where the storage medium so configured causes a computer system to operate in a specific and predefined manner to perform the functions described herein.

Some of the steps in the embodiments of the invention described above may be order independent, and thus can be performed in an order different from that described.

**Claims**

1.  A method for processing an audio signal, comprising
    producing, in response to the audio signal, an excitation signal, and
    calculating, in response at least to the excitation signal, a gain value G[t], the calculating including an iterative processing loop that includes at least one non-linear process and excludes producing the excitation signal,
    wherein the iterative processing loop includes
    adjusting the magnitude of the excitation signal in response to a function of an iteration gain value $G_i$ such that the adjusted magnitude of the excitation signal increases with increasing values of $G_i$ and decreases with decreasing values of $G_i$,
    calculating a perceptual loudness in response to the magnitude-adjusted excitation signal,
    comparing the calculated perceptual loudness of the audio signal to a reference perceptual loudness to generate a difference, and
    adjusting the gain value $G_i$ in response to the difference so as to reduce the difference between the calculated perceptual loudness and the reference perceptual loudness, and
    wherein the iterative processing loop, in accordance with a minimization algorithm, repetitively adjusts the magnitude of the excitation signal, calculates the perceptual loudness, compares the calculated perceptual loudness to a reference perceptual loudness, and adjusts the gain value $G_i$ to a final value $G[t]$,
    the method further comprising
    controlling the amplitude of the audio signal with the final gain value $G[t]$ so that the resulting perceptual loudness of the audio signal is substantially the same as the reference perceptual loudness.

2.  The method of claim 1 wherein producing said excitation signal includes temporal integration.

3.  The method of claim 2 wherein the excitation signal is linearly time smoothed.

4.  The method of claim 1 wherein the method further comprises time smoothing the final gain value G[t].

5.  The method of claim 1 wherein the method further comprises smoothing the final gain value G[t], said smoothing employing a histogram technique.

6.  A method according to claim 1, wherein the minimization algorithm operates in accordance with a gradient descent method of minimization.

7.  A method according to any one of claims 1 to 6 wherein the reference perceptual loudness is set by a user.

8. A method according to any one of claims 1-7 wherein the reference perceptual loudness is derived from a measure of the calculated perceptual loudness of the audio signal.

9. A method according to claim 8 wherein the reference perceptual loudness is a scaled version of the calculated perceptual loudness of the audio signal.

10. A method according to claim 9 wherein the reference perceptual loudness is greater than the calculated perceptual loudness of the audio signal when the calculated perceptual loudness of the audio signal is below a threshold and less than the calculated perceptual loudness of the audio signal when the calculated perceptual loudness of the audio signal is above a threshold.

11. Apparatus adapted to perform the methods of any one of claims 1 through 10.

12. A computer program, stored on a computer-readable medium for causing a computer to perform the methods of any one of claims 1 through 10.


**Patentansprüche**

1. Ein Verfahren zum Verarbeiten eines Audiosignals, das aufweist Erzeugen, in Reaktion auf das Audiosignal, eines Anregungssignals, und Berechnen, in Reaktion zumindest auf das Anregungssignal, eines Verstärkungswerts G[t], wobei das Berechnen eine iterative Verarbeitungsschleife umfasst, die zumindest einen nichtlinearen Prozess umfasst und ein Erzeugen des Anregungssignals ausschließt,
   wobei die iterative Verarbeitungsschleife umfasst
   Anpassen der Größe des Anregungssignals in Reaktion auf eine Funktion eines Iterations-Verstärkungswerts $G_i$ derart, dass die angepasste Größe des Anregungssignals mit zunehmenden Werten von $G_i$ zunimmt und mit abnehmenden Werten von $G_i$ abnimmt,
   Berechnen einer Wahrnehmungslautheit in Reaktion auf das größenangepasste Anregungssignal,
   Vergleichen der berechneten Wahrnehmungslautheit des Audiosignals mit einer Referenz-Wahrnehmungslautheit, um eine Differenz zu erzeugen, und Anpassen des Verstärkungswerts $G_i$ in Reaktion auf die Differenz, um die Differenz zwischen der berechneten Wahrnehmungslautheit und der Referenz-Wahrnehmungslautheit zu reduzieren, und
   wobei die iterative Verarbeitungsschleife, in Übereinstimmung mit einem Minimierungs-Algorithmus, die Größe des Anregungssignals wiederholend anpasst, die Wahrnehmungslautheit berechnet, die berechnete Wahrnehmungslautheit mit einer Referenz-Wahrnehmungslautheit vergleicht und den Verstärkungswert $G_i$ auf einen endgültigen Wert G[t] anpasst,
   wobei das Verfahren weiter aufweist
   Steuern der Amplitude des Audiosignals mit dem endgültigen Verstärkungswert G[t], so dass die resultierende Wahrnehmungslautheit des Audiosignals im Wesentlichen gleich zu der Referenz-Wahrnehmungslautheit ist.

2. Das Verfahren gemäß Anspruch 1, wobei das Erzeugen des Anregungssignals eine zeitliche Integration umfasst.

3. Das Verfahren gemäß Anspruch 2, wobei das Anregungssignal linear zeitlich geglättet ist.

4. Das Verfahren gemäß Anspruch 1, wobei das Verfahren weiter ein zeitliches Glätten des endgültigen Verstärkungswerts G[t] aufweist.

5. Das Verfahren gemäß Anspruch 1, wobei das Verfahren weiter ein Glätten des endgültigen Verstärkungswerts G[t] aufweist, wobei das Glätten eine Histogramm-Technik einsetzt.

6. Ein Verfahren gemäß Anspruch 1, wobei der Minimierungs-Algorithmus in Übereinstimmung mit einem Gradienten-Abfall-Verfahren zur Minimierung arbeitet.

7. Ein Verfahren gemäß einem der Ansprüche 1 bis 6, wobei die Referenz-Wahrnehmungslautheit von einem Benutzer gesetzt wird.

8. Ein Verfahren gemäß einem der Ansprüche 1 bis 7, wobei die Referenz-Wahrnehmungslautheit aus einem Maß der berechneten Wahrnehmungslautheit des Audiosignals abgeleitet wird.

**9.** Ein Verfahren gemäß Anspruch 8, wobei die Referenz-Wahrnehmungslautheit eine skalierte Version der berechneten Wahrnehmungslautheit des Audiosignals ist.

**10.** Ein Verfahren gemäß Anspruch 9, wobei die Referenz-Wahrnehmungslautheit größer ist als die berechnete Wahrnehmungslautheit des Audiosignals, wenn die berechnete Wahrnehmungslautheit des Audiosignals unter einer Schwelle ist, und kleiner ist als die berechnete Wahrnehmungslautheit des Audiosignals, wenn die berechneten Wahrnehmungslautheit des Audiosignals über einer Schwelle ist.

**11.** Vorrichtung, die ausgebildet ist zum Durchführen der Verfahren gemäß einem der Ansprüche 1 bis 10.

**12.** Ein Computerprogramm, das auf einem computerlesbaren Medium gespeichert ist, um einen Computer zu veranlassen, die Verfahren gemäß einem der Ansprüche 1 bis 10 durchzuführen.


**Revendications**

**1.** Procédé de traitement d'un signal audio comprenant :

- la production, en réponse au signal audio, d'un signal d'excitation et
- le calcul, en réponse à au moins le signal d'excitation, d'une valeur de gain G[t], le calcul incluant une boucle de traitement itérative qui inclut au moins un processus non linéaire et qui exclut la production du signal d'excitation,
dans lequel la boucle de traitement itérative inclut :
- l'ajustement de l'amplitude du signal d'excitation en réponse à une fonction d'une valeur de gain d'itération Gi de telle sorte que l'amplitude ajustée du signal d'excitation augmente avec les valeurs en augmentation de Gi et diminue avec les valeurs en diminution de *Gi*,
- le calcul d'un niveau sonore perceptible en réponse au signal d'excitation ajusté en amplitude,
- la comparaison du niveau sonore perceptible calculé du signal audio avec un niveau sonore perceptible de référence afin de générer une différence, et
- l'ajustement de la valeur de gain *Gi*, en réponse à la différence, de manière à réduire la différence entre le niveau sonore perceptible calculé et le niveau sonore perceptible de référence, et
dans lequel la boucle de traitement itérative, selon un algorithme de minimisation, ajuste de manière répétée, l'amplitude du signal d'excitation, calcule le niveau sonore perceptible, compare le niveau sonore perceptible calculé à un niveau sonore perceptible de référence, et ajuste la valeur de gain *Gi* sur une valeur finale G[t], le procédé comprenant en outre :
- le contrôle de l'amplitude du signal audio avec la valeur de gain finale G[t], de telle sorte que le niveau sonore perceptible résultant du signal audio soit sensiblement le même que le niveau sonore perceptible de référence.

**2.** Procédé selon la revendication 1, dans lequel la production dudit signal d'excitation inclut une intégratian. temporelle.

**3.** Procédé selon la revendication 2, dans lequel le signal d'excitation est lissé linéairement dans le temps.

**4.** Procédé selon la revendication 1, dans lequel le procédé comprend en outre le lissage dans le temps de la valeur de gain finale *G*[t].

**5.** Procédé selon la revendication 1, dans lequel le procédé comprend en outre le lissage de la valeur de gain finale G[t], ledit lissage employant une technique d'histogramme.

**6.** Procédé selon la revendication 1, dans lequel l'algorithme de minimisation fonctionne selon un procédé de minimisation à descente progressive.

**7.** Procédé selon l'une quelconque des revendications 1 à 6, dans lequel le niveau sonore perceptible de référence est fixé par un utilisateur.

**8.** Procédé selon l'une quelconque des revendications 1 à 7, dans lequel le niveau sonore perceptible de référence est dérivé d'une mesure du niveau sonore perceptible calculé du signal audio.

**9.** Procédé selon la revendication 8, dans lequel le niveau sonore perceptible de référence est une version à échelle réduite du niveau sonore perceptible calculé du signal audio.

10. Procédé selon la revendication 9, dans lequel le niveau sonore perceptible de référence est supérieur au niveau sonore perceptible calculé du signal audio lorsque le niveau sonore perceptible calculé du signal audio est en dessous d'un seuil et inférieur au niveau sonore perceptible calculé du signal audio lorsque le niveau sonore perceptible calculé du signal audio est au dessus d'un seuil.

11. Appareil conçu pour mettre en oeuvre les procédés selon l'une quelconque des revendications 1 à 10.

12. Programme informatique, stocké sur un support lisible par un ordinateur permettant de demander à un ordinateur de mettre en oeuvre les procédés selon l'une quelconque des revendications 1 à 10.

**FIG. 1**

*100*

*101*

Transmission Filter *102*

Filterbank *104*

Specific Loudness Control *124*

Time Averaging *106*

Specific Loudness *120*

Loudness *122*

*123*

**FIG. 2**

**FIG. 3**

*201*

*202* Transmission Filter

*204* Filterbank

*224* Specific Loudness Control

*206* Time Averaging

*200*

*208* ⊗

*220* Specific Loudness

*234*

*233* Iterative Gain Update

*221*

*222* Loudness

*231* ⊕ *232* + − *230* *235*

*223*

*236* VCA

Gain Adjusted Output Signal

FIG. 4

FIG. 5

**FIG. 6**

Level (dB) vs Frequency (Hertz)

**FIG. 7**

ISO226 Annex A "Equal Loudness Contours"

Sound Pressure Level (dB) vs Frequency (Hertz)

**FIG. 8**

ISO226 Annex A "Equal Loudness Contours" (normalized by the transmission filter)

**FIG. 9**

**FIG. 10**

EP 1 835 487 B1

**FIG. 11**

Gain Adjusted
Output Signal

**FIG. 12**

Gain Adjusted
Output Signal

**FIG. 13**

*250*

*TO 201* → 1st Channel Audio → **FIG. 3, 11** → *FROM 236* → Loudness - Adjusted 1st Channel Audio

*TO 230*

*252*

*TO 201* → Nth Channel Audio → **FIG. 3, 11** → *FROM 236* → Loudness - Adjusted Nth Channel Audio

*TO 230*

Reference Loudness Level

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5822018 A
- US 23307302 A
- US 20040044525 A1

**Non-patent literature cited in the description**

- Calculation of the Loudness of Complex Noise. *Journal of the Acoustical Society of America,* 1956
- Psychological and Methodical Basis of Loudness. *Acoustica,* 1958
- investigation into Loudness of Advertisements. *Australian Broadcasting Authority's,* July 2002
- **E. ZWICKER ; H. FASTL.** Psychoacoustics - Facts and Models. Springer-Verlag, 1990
- **B. C. J. MOORE ; B. GLASBERG ; T. BAER.** A Model for the Prediction of Thresholds, Loudness, and Partial Loudness. *Journal of the Audio Engineering Society,* April 1997, vol. 45 (4), 224-240
- **B. C. J. MOORE ; B. GLASBERG ; T. BAER.** *A Model for the Prediction of Thresholds, Loudness, and Partial Loudness*
- **N. S. JAYANT ; P. NOLL.** Digital Coding Of Waveforms. Prentice Hall, 1984
- **DIMITRI P. BERTSEAKAS.** Nonlinear Programming. Athena Scientific, 1995